Europäisches Patentamt

**European Patent Office**

Office européen des brevets

(11) Numéro de publication: **0 202 144**
**B1**

(12) **FASCICULE DE BREVET EUROPEEN**

(51) Int. Cl.⁴: **H05K 9/00**

(45) Date de publication du fascicule du brevet:
**06.12.89**

(21) Numéro de dépôt: **86400807.3**

(22) Date de dépôt: **15.04.86**

(54) **Dispositif d'étanchéité électromagnétique du type joint-couteau.**

(30) Priorité: **18.04.85 FR 8505877**

(43) Date de publication de la demande:
**20.11.86 Bulletin 86/47**

(45) Mention de la délivrance du brevet:
**06.12.89 Bulletin 89/49**

(84) Etats contractants désignés:
**DE GB IT NL**

(56) Documents cités:
**EP-A- 0 095 743**
**EP-A- 0 113 852**
**DE-B- 2 451 192**
**US-A- 3 589 070**

(73) Titulaire: **THOMSON-CSF, 51, Esplanade du Général de Gaulle, F-92800 Puteaux(FR)**

(72) Inventeur: **Side, Solly, THOMSON-CSF SCPI 19, avenue de Messine, F-75008 Paris(FR)**
Inventeur: **Magnat, Jean-Pierre, THOMSON-CSF SCPI 19, avenue de Messine, F-75008 Paris(FR)**
Inventeur: **Bellot, Guy, THOMSON-CSF SCPI 19, avenue de Messine, F-75008 Paris(FR)**

(74) Mandataire: **Courtellemont, Alain et al, THOMSON-CSF SCPI, F-92045 PARIS LA DEFENSE CEDEX 67(FR)**

# Description

La présente invention se rapporte à un dispositif d'étanchéité pour enceintes du type cage de Faraday. Ce dispositif, du type joint-couteau, sert à rendre étanche aux ondes électromagnétiques et aux courants électriques, la jonction entre deux pièces dont l'une comporte un orifice et dont l'autre constitue un panneau pour la fermeture de l'orifice ; à cet effet une sorte de couteau métallique, aussi appelé sabre, solidaire d'une des pièces, est destiné à venir en contact avec un joint métallique souple, solidaire de l'autre pièce, suivant une ligne fermée qui entoure l'ouverture. Un tel dispositif est connu du document DE-B 2 451 192.

Il est connu d'employer comme joint, dans ces dispositifs, une tige souple en caoutchouc, entourée d'une gaine métallique, tubulaire, tricotée ; ce joint rendu solidaire de l'une des deux pièces métalliques, est écrasé ou pincé entre les deux pièces grâce au couteau et assure, par sa gaine, le contact électrique entre les deux pièces. Les dispositifs connus comportant de tels joints, présentent des inconvénients : la fixation du joint, généralement par collage, est délicate ce qui est gênant s'il faut le changer - la gaine métallique tricotée est fragile et supporte mal, à l'endroit du contact avec le couteau, les opérations répétées d'ouverture et de fermeture de l'orifice - l'étanchéité radioélectrique aux très hautes fréquences est médiocre.

Il est également connu d'employer comme joint dans ces dispositifs, des joints dits américains, voir par ex. US-A 3 589 070, qui sont des sortes de peignes découpés dans des feuilles métalliques et dont les dents larges présentent, dans la section transversale du peigne, une courbure importante ; cette courbure assure l'élasticité des dents du peigne quand le couteau vient en contact en appuyant perpendiculairement au plan du peigne, soit par sa tranche dans un déplacement perpendiculaire au plan du peigne, soit par une de ses faces dans un déplacement parallèle au plan du peigne. Les dispositifs connus, qui comportent ces joints, présentent des inconvénients : les dents du peigne sont fragiles et, quand elles cassent, le remplacement du peigne, qui est généralement vissé, est relativement long.

Il est aussi connu d'employer des joints formés de deux bandes repliées selon des plis longitudinaux ; ces joints sont maintenus par une sorte de pince, respectivement sur les deux bords opposés d'une tranchée à l'intérieur de laquelle pénètre un couteau. Un tel ensemble est cher, de par sa relative complexité mécanique.

La présente invention a pour but d'éviter ou pour le moins de réduire les difficultés susmentionnées.

Ceci est obtenu grâce à un joint en U disposé dans un support du genre gouttière, avec un couteau qui pénètre dans la gouttière en appuyant sur le fond et sur les parois latérales du joint.

Selon l'invention un dispositif d'étanchéité électromagnétique du type joint-couteau, est caractérisé en ce que la bande métallique est pliée pour former une rigole, la bande pliée présentant n renflements longitudinaux (n entier positif), à convexité tournée vers l'intérieur de la rigole ; en ce que la tranchée est munie, sur sa paroi interne, de deux butées longitudinales disposées respectivement au voisinage des deux bords de cette tranchée, la bande étant disposée à l'intérieure de la tranchée et y étant maintenue par appui de ses deux bords respectivement sur les deux butées ; et en ce que le couteau est destiné à pénétrer dans la rigole et à appuyer sur les renflements.

La présente invention sera mieux comprise et d'autres caractéristiques apparaîtront à l'aide de la description ci-après et des figures s'y rapportant qui représentent :

- la figure 1, un joint pour dispositif d'étanchéité selon l'invention,
- les figures 2a et 2b, le joint de la figure 1 disposé respectivement dans un premier et un second support,
- la figure 3, un dispositif d'étanchéité selon l'invention,
- les figures 4 et 5, des vues relatives à l'association de deux éléments de joints d'un dispositif d'étanchéité selon l'invention.

Sur les différentes figures les éléments correspondants sont désignés par les mêmes repères.

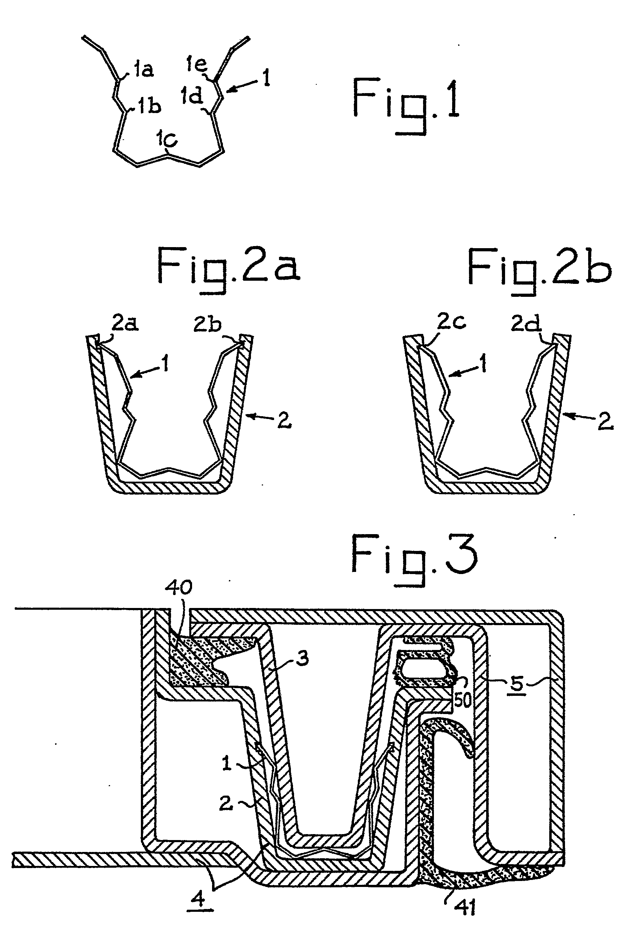

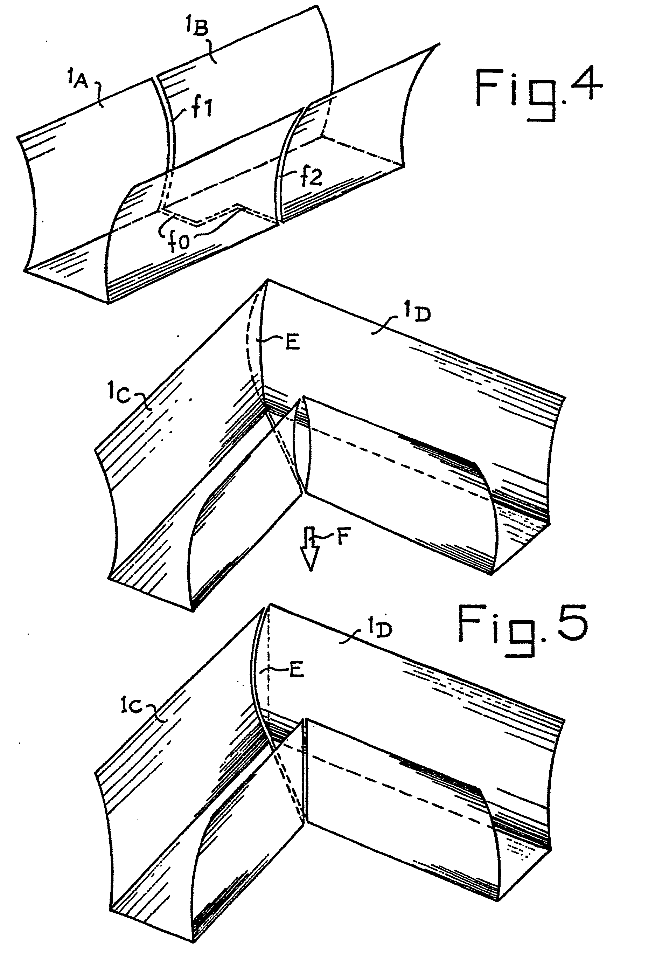

La figure 1 montre, vu en coupe transversale, un joint, 1, pour dispositif d'étanchéité électromagnétique du type joint-couteau. Il s'agit d'une pièce métallique en forme de rigole, réalisée par pliages longitudinaux d'une bande métallique de 88 mm de large et 0,2 mm d'épaisseur en alliage de cuivre et fer à 2,3% de fer ; un traitement par recuit confère à ce joint souplesse et dureté. Le fond et les parois latérales de la rigole présentent, en tout, cinq renflements tournés vers l'intérieur de la rigole : 1c pour le fond, 1a, 1b pour l'une des parois, 1d, 1e pour l'autre paroi.

La figure 2a montre, toujours vu en coupe transversale, le joint, 1, de la figure 1 après qu'il ait été placé dans un support 2. Ce support forme une sorte de tranchée dont la coupe transversale est sensiblement celle d'une auge et dont les parois latérales sont creusées chacune d'une rainure longitudinale, 2a, 2b, située au voisinage du haut de la paroi. Le joint 1 est introduit dans le support 2 de telle manière que le fond de la rigole vienne au voisinage du fond de la tranchée. Du fait que lorsque le joint 2 n'est soumis à aucune contrainte, l'écartement des bords de la bande qui le constituent, est environ de 40 mm, c'est-à-dire supérieur de plusieurs millimètres à l'espace, qui lui est laissé entre les parois en regard du support 2, il est nécessaire de rapprocher ses bords pour l'introduire dans son support ; ceci est possible du fait de l'élasticité du joint 1. Les bords, en venant s'encliqueter respectivement dans les rainures 2a, 2b, qui forment butées, bloquent le joint dans son support 2. Pour faire ressortir le joint 1 de son support 2 il faut alors le saisir à l'une de ses extrémités et rapprocher ses parois en regard.

La figure 2b est une vue en coupe transversale illustrant un second exemple de réalisation de dispositif d'étanchéité selon l'invention. La figure 2b se distingue seulement de la figure 2a par le fait que le support 2 présente, pour retenir le joint 1, non pas deux butées longitudinales du type rainures mais deux butées longitudinales du type décrochements, 2c et 2d. Ces butées 2c et 2d sont, dans l'exemple décrit, obtenues par usinage du support 2 avant le pliage qui lui donne sa coupe en auge ; il est également possible d'obtenir des butées du type décrochements par pliage.

La figure 3 est une vue partielle, en coupe, d'une armoire du type cage de Faraday comportant l'ensemble constitué par le joint 1 et le support 2 qui ont été décrits à l'aide des figures 1 et 2a. Le joint 1 et le support 2 sont deux des éléments d'une porte 4, qui est également munie de joints, en caoutchouc 40, 41. La figure 3 montre également une partie du châssis fixe 5 de la porte ; ce châssis fixe est muni d'un couteau, 3, et d'un joint d'étanchéité en caoutchouc 50 destiné à coopérer avec les joints 40 et 41 pour assurer l'étanchéité aux poussières et à l'eau de la liaison entre la porte 4 et le châssis 5. Dans la représentation selon la figure 3, la porte est fermée si bien que le couteau 3 a pénétré dans le joint 1 ; par comparaison avec la figure 2a, il est à remarquer que la pénétration du couteau 3 dans la rigole que constitue le joint 1, en appuyant d'abord sur les renflements 1a, 1e (voir figure 1), puis sur 1b, 1d, et sur 1c, a pour effet de plaquer fortement le joint contre les parois de l'espace restant libre entre le support 2 et le couteau 3. La figure 3 montre qu'il y a contact en onze endroits entre le joint 1 et les parois qui l'entourent : contact avec le couteau 3 au niveau des cinq renflements et contact avec le support 2 en six endroits (dont ceux avec les bords de la bande qui constitue le joint 1).

Les figures 4 et 5 montrent comment peuvent être effectuées des juxtapositions de joints pour dispositifs d'étanchéité selon l'invention. Il s'agit ici de joints légèrement différents de celui qui a été décrit à l'aide des figures 1 à 3, dans la mesure où, tout en ayant encore la forme d'une rigole, ils ne comportent pas les cinq renflements 1a à 1e repérés sur la figure 1 mais seulement deux renflements constitués par des parois latérales bombées avec leur convexité tournée vers l'intérieur de la rigole ; néanmoins les joints qui sont représentés sur les figures 4 et 5 sont, dans les exemples décrits, des joints interchangeables avec celui des figures 1 à 3.

La figure 4 montre deux joints 1A, 1B mis bout à bout dans un support dont la section est celle du support 2 des figures 2a et 3 ; ces joints sont dans la position qu'ils occupent avant pénétration d'un couteau. Pour mieux montrer la façon selon laquelle est réalisé le raccordement, seuls les joints sont représentés. Les deux joints peuvent être considérés comme un joint unique dont les parois verticales et le fond auraient été découpés respectivement par des fentes verticale f1, f2. Pour éviter les fuites électromagnétiques au niveau du raccordement, les fentes f1 et f2 ne sont pas disposées face à face mais sont décalées l'une par rapport à l'autre grâce à une découpe du fond du joint par une fente f0 en zigzag.

La figure 5 montre deux joints 1C, 1D dans la position qu'ils occupent avant et après l'introduction à l'intérieur de chacun d'eux d'un couteau du type du couteau 3 de la figure 3. Une flèche F va de la position avant introduction des couteaux à la position après introduction des couteaux ; dans ce qui suit ces positions seront dites respectivement position "avant" et position "après". Comme dans le cas de la figure 4 seuls les joints ont été représentés. Ces joints sont disposés à 90° l'un de l'autre, formant ainsi une rigole coudée à angle droit.

Dans la position "avant", les parois de l'angle saillant (vu de l'intérieur de la rigole) sont découpées de telle sorte que la paroi du joint 1E épouse à son extrémité correspondant à l'angle, sensiblement la courbure de la paroi du joint 1D tandis que la paroi du joint ne s'arrête pas à l'extrémité considérée du joint 1C mais la dépasse légèrement, selon une surface E, de manière à réduire au mieux la fente entre les parois 1C et 1D dans la position "après".

Dans la position "avant", comme dans la position "après" des découpes à 45° par rapport aux directions longitudinales, non représentées, de chacun des joints permet une liaison à bords parallèles.

En ce qui concerne les parois de l'angle rentrant (vu de l'intérieur de la rigole), les extrémités des parois des joints 1C, 1D qui y aboutissent sont découpées de manière que, dans la position "après", ces extrémités soient sensiblement parallèles.

L'invention n'est pas limitée aux exemples décrits, elle s'applique en particulier à tout dispositif d'étanchéité du type joint-couteau dans lequel le joint a la forme d'une rigole et comporte au moins un renflement longitudinal à convexité tournée vers l'intérieur de la rigole, dans lequel un support en forme de tranchée avec butées longitudinales maintient le joint et dans lequel un couteau, en pénétrant dans la rigole, appuie sur le ou les renflements et comprime ainsi le joint dans l'espace laissé libre entre le support et le couteau.

## Revendications

1. Dispositif d'étanchéité électromagnétique du type comprenant un joint (1) constitué d'une bande métallique, un support (2) formant une tranchée, et un couteau (3) qui pénêtre dans la tranchée et fait contact avec la bande métallique, caractérisé en ce que: la bande métallique est pliée pour former une rigole, la bande pliée présentant n renflements longitudinaux (n entier positif), à convexité tournée vers l'intérieur de la rigole ; en ce que la tranchée est munie de deux butées longitudinales (2a, 2b ; 2c, 2d) disposées sur sa paroi interne, respectivement au voisinage des deux bords de cette tranchée, la bande étant disposée à l'intérieur de la tranchée et y étant maintenue par appui de ses deux bords longitudinaux respectivement sur les deux butées ; et en ce que le couteau (3) est destiné à pénétrer dans la rigole et à appuyer sur les renflements.

2. Dispositif selon la revendication 1, caractérisé en ce que la rigole a une section en auge dont le fond comporte un des renflements (1c) et dont les parois latérales comportent chacune au moins un des renflements (1a, 1b, 1d, 1e).

3. Dispositif selon la revendication 1, caractérisé en ce que les butées sont des rainures (2c, 2d) dans lesquelles les bords de la bande sont encliquetés.

4. Dispositif selon la revendication 1, caractérisé en ce que les butées sont des décrochements (2c, 2d).

## Claims

1. An electromagnetic sealing device comprising a joint (1) which is constituted of a metal band, a support (2) which forms a trench, and a knife (3) which penetrates into the trench and enters into contact with the metal band, characterized in that the metal band is folded to form a drain, the folded band being provided with n longitudinal bulges (n being a positive integer) with the convexity pointing to the inside of the drain, that the trench is provided with longitudinal stops (2a, 2b; 2c, 2d) disposed on its inner wall near the two borders of said trench respectively, the band being disposed within the trench and held therein by having its two longitudinals rims bearing respectively against the two stops, and that the knife (3) is intended to penetrate into the drain and to bear against the bulges.

2. A device according to claim 1, characterized in that the drain presents the cross-section of a trough, whose bottom comprises one of the bulges (1c) and whose lateral walls comprise each at least one of the bulges (1a, 1b, 1d, 1e).

3. A device according to claim 1, characterized in that the stops are formed by grooves (2c, 2d) in which the rims of the band are locked.

4. A device according to claim 1, characterized in that the stops are formed by offset shoulders (2c, 2d).

## Patentansprüche

1. Elektromagnetische Abdichtvorrichtung mit einer aus einem Metallband bestehenden Dichtung (1), einem grabenförmigen Träger (2) und einem Messer (3), das in den Graben eindringt und Kontakt mit dem Metallband bekommt, dadurch gekennzeichnet, daß das Metallband unter Bildung einer Rinne gefaltet ist, wobei das gefaltete Band n Längsausbauchungen mit zur Innenseite der Rinne hin gerichteten Wölbungen aufweist (n ist eine ganze positive Zahl), daß der Graben mit zwei Längsanschlägen (2a, 2b; 2c, 2d) versehen ist, die sich auf seiner Innenwandung bzw. in der Nähe der beiden Grabenränder befinden, wobei das Band im Inneren des Grabens angeordnet und dort durch Abstützung seiner beiden Längskanten an den beiden Anschlägen gehalten wird, und daß das Messer (3) zum Eindringen in die Rinne und zum Abstützen auf den Ausbauchungen bestimmt ist.

2. Vorrichtung nach Anspruch 1, dadurch gekennzeichnet, daß die Rinne den Querschnitt eines Troges besitzt, dessen Boden eine der Ausbauchungen (1c) und dessen Seitenwände jeweils mindestens eine der Ausbauchungen (1a, 1b, 1d, 1e) aufweisen.

3. Vorrichtung nach Anspruch 1, dadurch gekennzeichnet, daß die Anschläge durch Nuten (2c, 2d) gebildet sind, in welche die Kanten des Bandes eingerastet sind.

4. Vorrichtung nach Anspruch 1, dadurch gekennzeichnet, daß die Anschläge durch Abkröpfungen (2c, 2d) gebildet sind.

Fig.1

Fig.2a

Fig.2b

Fig.3

Fig.4

Fig.5